# EUROPEAN PATENT APPLICATION

(11) **EP 4 641 232 A1**
(43) Date of publication of application: **29.10.2025**
(21) Application number: 24868646.1
(22) Date of filing: 13.09.2024
(51) Int. Cl.: G01R 31/392, G01R 31/396, G01R 31/382, G01R 31/385, G01R 19/165, G01R 19/30, B60L 58/16

(54) **APPARATUS AND METHOD FOR MANAGING BATTERY**

(30) Priority: 21.09.2023 KR 20230126117
(71) Applicant: LG Energy Solution, Ltd., Seoul 07335 (KR)
(72) Inventor: KIM, Ji-Yeon, Daejeon 34122 (KR); KIM, Young-Deok, Daejeon 34122 (KR); PARK, Hyun-Joo, Daejeon 34122 (KR)
(74) Representative: Goddar, Heinz J.
(86) International application number: PCT/KR2024/014060
(87) International publication number: WO 2025/063669

(57) **Abstract**

A battery management apparatus according to an embodiment of the present disclosure includes a profile processing unit configured to obtain a charging and discharging profile of a cell group in which a plurality of cells are electrically connected; a characteristic point selecting unit configured to select a characteristic point corresponding to an inflection point in the charging and discharging profile; and a diagnosing unit configured to diagnose a deterioration imbalance of the cell group using characteristic information including information on the number of characteristic points.

## Description

### TECHNICAL FIELD

This application is based on and claims priority from Korean Patent Application No. 10-2023-0126117, filed on September 21, 2023, with the Korean Intellectual Property Office, the disclosure of which is incorporated herein in its entirety by reference.

The present disclosure relates to a technology for diagnosing and managing a state of a battery, and more specifically, to a battery management apparatus and method for effectively diagnosing whether there is a deterioration imbalance in a cell group.

### BACKGROUND ART

As the demand for portable electronic products such as laptops, video cameras, and mobile phones that use electricity as a power source increases rapidly, and as mobile robots, electric bicycles, electric carts, and electric vehicles become more widely commercialized, research on high-performance secondary batteries capable of repeated charging and discharging is actively being conducted.

Commercialized secondary batteries include nickel-cadmium batteries, nickel hydride batteries, nickel-zinc batteries, and lithium secondary batteries. Among them, lithium secondary batteries have the advantage of being free to charge and discharge and having a very low self-discharge rate compared to nickel-based secondary batteries, with almost no memory effect, and also they have the characteristics of high energy density and high operating voltage, and are therefore being studied more intensively than other types of secondary batteries and are being applied more widely in actual products.

Recently, secondary batteries are widely used not only in small devices such as portable electronic devices, but also in medium and large devices such as electric vehicles and energy storage systems (ESSs).

In this case, a battery module in which a number of electrically connected secondary batteries are stored together inside a module case is mainly applied. Furthermore, in cases where high power or large capacity is required, a battery pack in which a number of such battery modules are electrically connected is also applied.

Secondary battery cells, cell assemblies, battery modules, or battery packs (hereinafter collectively referred to as 'batteries') are important factors for power efficiency and safety. Accordingly, research is also actively being conducted on BMS (Battery Management System), which monitors the electrical characteristics of the battery and performs feedback control such as charging and discharging using the monitoring results.

Unlike the method of generating energy based on fossil fuels, secondary cell-based batteries generate energy through electrochemical reactions. Thus, as the charge/discharge cycle continues or is repeated, they cannot maintain the performance of the initial manufacturing stage, i.e. the BOL (Beginning Of Life) state, and gradually deteriorate or age.

As the battery continues to be used (charged and discharged), its usability decreases due to deterioration in capacity and output, and its safety also becomes a risk factor. Therefore, in order to control limited use, determine replacement timing, objectively determine prices for battery sharing or subscription, and improve the efficiency of battery reuse or recycling, it is necessary to accurately predict the current battery deterioration rate and its remaining lifespan.

Meanwhile, a plurality of battery cells constituting a battery may have different electrical characteristic values or different degrees of aging or deterioration of their inherent driving performance due to inherent characteristics such as internal resistance, artificial deviations due to the usage environment, and differences in individual dynamic states caused by cooling efficiency, capacity, etc. (hereinafter referred to as 'deterioration imbalance').

Deterioration imbalance may occur not only when the degree of deterioration of each cell is different depending on its use, but also due to defects in the manufacturing process.

When the deterioration levels of the plurality of cells grouped through electrical connection are different in this way, the operating performance of the entire cell group deteriorates. Therefore, a technology is required to accurately diagnose the occurrence of deterioration imbalance in a cell group in which a plurality of cells are electrically connected so that subsequent processing or operation, such as restricted use, exclusion of charging and discharging, and determination of replacement time, may be more effectively induced.

However, most of the existing methods or techniques for diagnosing deterioration are methods for predicting deterioration or remaining lifespan for each individual cell, so it may be difficult to effectively diagnose deterioration imbalance or deterioration unevenness for the entire cell group in which a plurality of cells are grouped.

Furthermore, even if the deterioration imbalance of a cell group is diagnosed using a conventional method, the deterioration calculation for each individual cell must be completed, and then functional processing such as statistical calculation and comparison must be performed again. Therefore, the efficiency of the calculation processing is considerably low, and also the accuracy of the information may also be reduced.

### DISCLOSURE

### Technical Problem

The present disclosure is designed to solve the problems of the related art, and therefore the present disclosure is directed to providing a battery management apparatus and method capable of quickly and accurately diagnosing the presence and/or degree of deterioration imbalance in a cell group through processing that identifies characteristic information of a charging and discharging profile for the entire cell group or a differential profile thereof.

The technical problems that the present disclosure seeks to solve are not limited to the problems described above, and other problems that are not mentioned will be clearly understood by those skilled in the art from the description of the invention described below.

### Technical Solution

A battery management apparatus according to one aspect of the present disclosure may comprise: a profile processing unit configured to obtain a charging and discharging profile of a cell group in which a plurality of cells are electrically connected; a characteristic point selecting unit configured to select a characteristic point corresponding to an inflection point in the charging and discharging profile; and a diagnosing unit configured to diagnose a deterioration imbalance of the cell group using characteristic information including information on the number of characteristic points.

The diagnosing unit may be configured to diagnose that the deterioration imbalance does not occur in the cell group if the number of characteristic points is single.

The diagnosing unit may be configured to diagnose that the deterioration imbalance occurs in the cell group if the number of characteristic points is multiple.

The charging and discharging profile may be a profile that represents a correspondence relationship between voltage and capacity of the cell group.

The characteristic point selecting unit may include a function processing unit configured to generate a differential profile, which is a profile representing a correspondence relationship between the capacity and a differential voltage of the cell group or a correspondence relationship between the voltage and a differential capacity of the cell group, based on the charging and discharging profile; and a point selecting unit configured to select the characteristic point in the differential profile.

When the differential profile representing the correspondence relationship between the capacity and the differential voltage is generated, the point selecting unit may be configured to determine a capacity having a smallest corresponding differential voltage in the generated differential profile and select the characteristic point among a plurality of peaks included in a capacity range greater than the determined capacity.

When the differential profile representing the correspondence relationship between the voltage and the differential capacity is generated, the point selecting unit may be configured to determine a voltage having a largest corresponding differential capacity in the generated differential profile and select the characteristic point among a plurality of peaks included in a voltage range greater than the determined voltage.

The point selecting unit may be configured to select a peak, in which a SOC of the cell group is located in a range of 40% or more and 70% or less, among the peaks as the characteristic point.

The battery management apparatus according to another aspect of the present disclosure may further comprise a management control unit configured to change a usage condition of the cell group so that charging and discharging of the cell group is limited, when the deterioration imbalance is diagnosed to occur in the cell group.

When the characteristic point is multiple, the characteristic information may further include disparity information between the characteristic points.

The diagnosing unit may be configured to generate diagnostic data including severity information that increases as the disparity information increases as information on the degree of the deterioration imbalance.

The battery management apparatus according to still another aspect of the present disclosure may further comprise a management control unit configured to change a usage condition of the cell group so that a charging and discharging range of the cell group is differentially limited according to a size of the disparity information, when the deterioration imbalance is diagnosed to occur in the cell group.

A battery pack according to still another aspect of the present disclosure may comprise the battery management apparatus according to an aspect of the present disclosure.

A vehicle according to still another aspect of the present disclosure may comprise the battery management apparatus according to an aspect of the present disclosure.

A battery management method according to still another aspect of the present disclosure may comprise: a profile processing step of obtaining a charging and discharging profile of a cell group in which a plurality of cells are electrically connected; a characteristic point selecting step of selecting a characteristic point corresponding to an inflection point in the charging and discharging profile; and a diagnosing step of diagnosing a deterioration imbalance of the cell group using characteristic information of the characteristic point.

### Advantageous Effects

According to the present disclosure, rather than a microscopic viewpoint of individual cells, it is possible to accurately diagnose deterioration imbalance at the cell group level applied to actual applications such as banks, modules, and battery packs, thereby improving the effectiveness of battery control and management.

According to one aspect of the present disclosure, it is possible to simply and accurately diagnose the presence and/or degree of deterioration imbalance in a cell group through software processing targeting the charging and discharging profile of the cell group or the differential profile thereof.

In this respect, the diagnostic method by the present disclosure may be implemented through software that may be installed in BMS, etc., or a module that implements the same, thereby providing higher expandability.

In addition, in the case of the present disclosure, the severity information of deterioration imbalance may be effectively combined with processing that differentially applies the usage restriction range of the corresponding cell group, thereby further increasing the efficiency of battery management processing.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a block diagram illustrating a detailed configuration of a battery management apparatus according to an embodiment of the present disclosure.
FIG. 2 is a block diagram showing a detailed configuration of a characteristic point selecting unit illustrated in FIG. 1.
FIG. 3 is a flow chart illustrating a processing process according to an embodiment of the present disclosure.
FIG. 4 is a flow chart illustrating a processing process according to another embodiment of the present disclosure.
FIG. 5 is a flow chart illustrating a processing process according to still another embodiment of the present disclosure.
FIG. 6 is a drawing illustrating a differential profile of a reference cell group.
FIG. 7 is a drawing illustrating a differential profile of a target cell group.
FIG. 8 is a drawing illustrating a characteristic point of a differential profile.
FIGS. 9 and 10 are drawings illustrating a disparity of a plurality of characteristic points (peaks).
FIG. 11 is a diagram schematically showing a vehicle according to another embodiment of the present disclosure.
FIG. 12 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

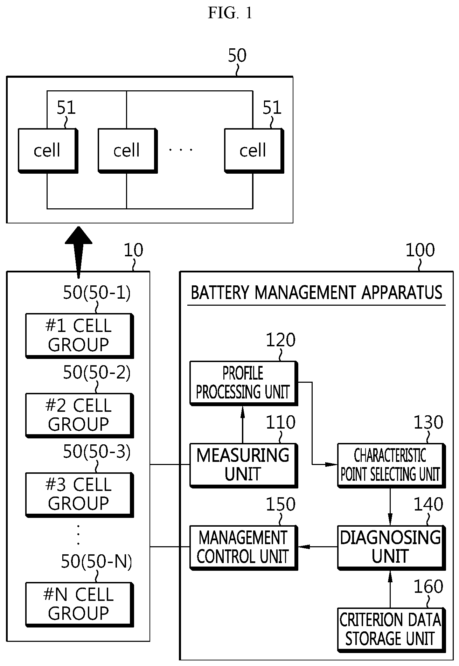

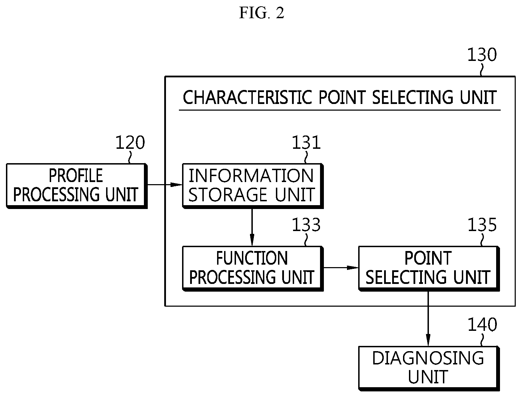

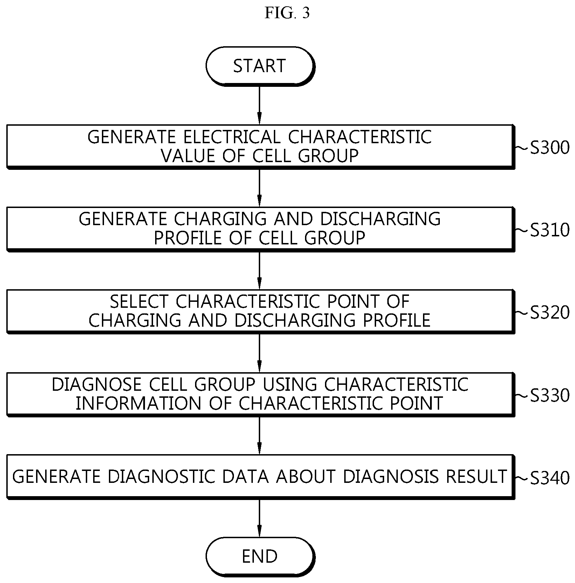

FIG. 1 is a block diagram illustrating a detailed configuration of a battery management apparatus 100 according to an embodiment of the present disclosure. FIG. 2 is a block diagram showing a detailed configuration of a characteristic point selecting unit illustrated in FIG. 1. FIG. 3 is a flow chart illustrating a processing process according to an embodiment of the present disclosure.

First, with reference to FIG. 1 and related drawings, etc., the detailed configuration of the battery management apparatus 100 according to the present disclosure and the processing performed by these configurations will be described in detail, and the detailed description of the characteristic point selecting unit 130 will be provided later.

Referring to FIG. 1, the battery management apparatus 100 may include a measuring unit 110, a profile processing unit 120, a characteristic point selecting unit 130, a diagnosing unit 140, a management control unit 150, and a criterion data storage unit 160.

Specifically, the characteristic point selecting unit 130 may be configured to include an information storage unit 131, a function processing unit 133, and a point selecting unit 135, as illustrated in FIG. 2, according to an embodiment.

Before going into the detailed description of the present disclosure, it is obvious that the battery management apparatus 100 according to the present disclosure may be implemented through various combinational applications of electronic devices, parts, etc., such as storage means, calculation processing means, input/output means, etc. Therefore, each component of the battery management apparatus 100 illustrated in FIG. 1 should be understood as a functionally or logically distinct component rather than a physically distinct component. Each component of the characteristic point selecting unit 130 illustrated in FIG. 2 is also the same.

That is, since each component depicted in the drawing corresponds to a logical structure for effectively explaining the technical idea by the present disclosure, even if each component is configured integrated or separately, if the function performed by the logical structure of the present disclosure can be realized, it should be interpreted as being within the scope of the present disclosure, and if it is a component that performs the same or similar function, it should of course be interpreted as being within the scope of the present disclosure regardless of the consistency in their names.

In addition, the battery management method by the present disclosure may be implemented as a set or algorithm of processing for data processing, handling, control, operation, input/output, etc., and thus, it may be implemented by a combination of logical structures shown in FIG. 1, etc., as well as in the form of software that is installed and operated in a system, device, computer (or a device equivalent thereto), BMS, module, or lower-level components thereof.

The battery management apparatus 100 of the present disclosure is configured to diagnose whether a deterioration imbalance occurs and/or the degree of deterioration imbalance (hereinafter referred to as "severity") in a cell group 50 in which a plurality of cells 51 are electrically connected, and may be configured to generate and output diagnostic data for the corresponding cell group 50 for organic linkage with other configurations or modules/devices, depending on the embodiment.

As illustrated in FIG. 1, it goes without saying that the cell group 50 diagnosed and managed by the battery management apparatus 100 according to the present disclosure may be provided in plurality (50-1, 50-2, 50-3, ..., 50-N) in the target battery 10, which is an upper group.

In addition, although FIG. 1 illustrates that a plurality of cells 51 constituting the cell group 50 are connected in parallel, this is only an example, and it is to be understood that, depending on the embodiment, each of the cells 51 connected in parallel may have a form in which a plurality of unit cells are connected in series.

The profile processing unit 120 of the present disclosure is configured to obtain a charging and discharging profile of the cell group 50 in which a plurality of cells are electrically connected. Here, the charging and discharging profile means a profile indicating a correspondence relationship between voltage and capacity of the cell group 50. Meanwhile, the capacity may be replaced with SOC (State of charge). That is, according to an embodiment, the charging and discharging profile may mean a profile indicating a correspondence relationship between voltage and SOC.

The charging and discharging profile may be stored and utilized in the profile processing unit 120 of the present disclosure by being input from a separately provided device or module, etc.

In addition, according to the embodiment, the measuring unit 110 may measure the voltage, current, etc. of the cell group 50 during the charging or discharging process to generate electrical characteristic values of the cell group 50 (S300, see FIG. 3). The profile processing unit 120 may of course generate a charging and discharging profile based on the generated electrical characteristic values (S310). According to the embodiment, the charging and discharging profile may be a data set in which voltage values and capacity values measured at the same time are mapped.

SOC is a parameter that represents the current capacity with respect to the maximum capacity as 0 to 1 or 0% to 100%, and various techniques and technologies such as ampere counting, equivalent circuit model (ECM), Kalman filter, etc. may be applied, and depending on the embodiment, temperature information may be further reflected to generate information on SOC.

When the charging and discharging profile is generated in this way (S310), the characteristic point selecting unit 130 selects a characteristic point corresponding to the inflection point in the charging and discharging profile (S320).

The inflection point may be a point at which the trend of slope changes based on the graph shape or curve shape of the charging and discharging profile. That is, the inflection point means a point at which the sign of slope increase rate changes (from positive to negative or from negative to positive), and means a point at which a change in the shape of the irregularities, that is, a change from convex (upward convex) to concave (downward convex) occurs in the graph of the charging and discharging profile.

The inflection point is a point where a change occurs due to the intrinsic characteristics of the cell 51 or the cell group 50, which is a collection of a plurality of cells, and may function as an important parameter point that may define the intrinsic state or characteristics of the cell 51, etc.

Of course, the specification or selection of such inflection points may be done by tools or algorithms that parse graph shapes, and the differential profile of the charging and discharging profile may be used to more clearly and accurately specify the inflection point through numerical analysis, etc. The details of the present disclosure regarding this will be described later.

When a characteristic point corresponding to the inflection point of the charging and discharging profile is selected in this way, the diagnosing unit 140 is configured to diagnose the deterioration imbalance of the corresponding cell group 50 using the characteristic information of the characteristic point.

Specifically, the characteristic information may include information on the number of characteristic points.

For example, if the number of characteristic points is single, the diagnosing unit 140 may be configured to diagnose that deterioration imbalance does not occur in the cell group. Conversely, if the number of characteristic points is multiple, the diagnosing unit 140 may diagnose that deterioration imbalance occurs in the cell group (S330).

For example, in the case of the cell group 50 (hereinafter referred to as 'reference cell group') including only cells in the BOL (Beginning Of Life) state (excluding cases where defective cells are mixed during the manufacturing process, etc.), the electrochemical behavior characteristics of individual cells constituting the reference cell group are substantially identical, so that a single characteristic point may be selected from the charging and discharging profile of the reference cell group. This is because the states of the plurality of cells included in the reference cell group are substantially identical.

In addition, even if the deterioration degree according to the use (charge/discharge) of each of the plurality of cells 51 included in the cell group 50 is substantially the same, the number of characteristic points selected from the charging and discharging profile of the cell group 50 may be single. This is because the deterioration of the plurality of cells 51 included in the cell group 50 is uniform.

In contrast, if a deterioration imbalance occurs between the plurality of cells 51 belonging to the cell group 50, multiple characteristic points may be selected from the charging and discharging profile of the cell group 50. This is because the characteristics of the plurality of cells 51 with deterioration imbalance are comprehensively reflected in the charging and discharging profile of the cell group 50.

The battery management apparatus 100 of the present disclosure may simply and accurately diagnose the deterioration imbalance of the cell group 50 by utilizing the characteristic change in the shape of the charging and discharging profile, that is, the phenomenon of differentiation or separation (split) of the characteristic point (inflection point) confirmed in the charging and discharging profile.

According to an embodiment, for subsequent control processing or organic linkage with other components as described above, the diagnosing unit 140 may be configured to generate diagnostic data containing the diagnosis results (S340).

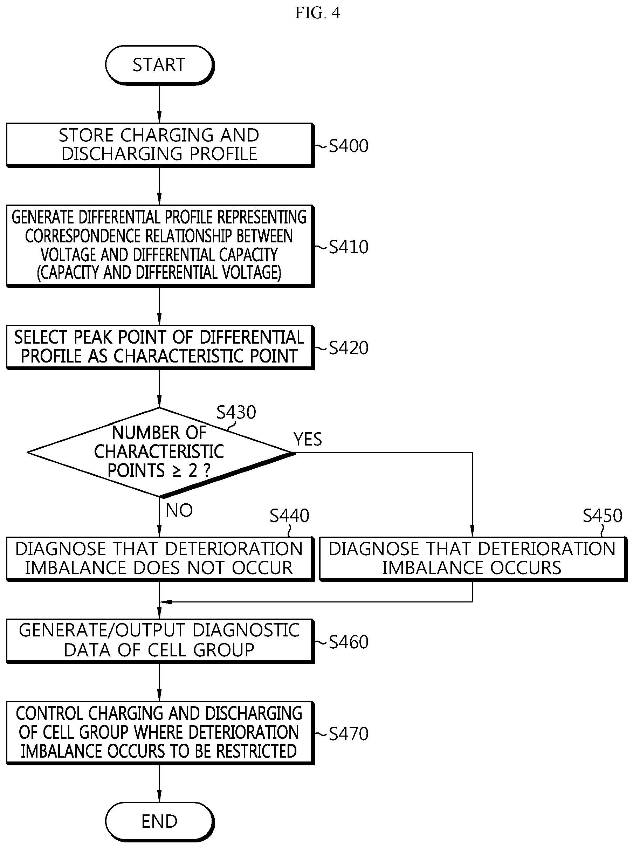

FIG. 2 is a block diagram showing the detailed configuration of the characteristic point selecting unit 130 illustrated in FIG. 1, and FIG. 4 is a flow chart illustrating a processing process according to another embodiment of the present disclosure.

The characteristic point selecting unit 130 may select a characteristic point corresponding to the inflection point in the charging and discharging profile, as described above.

Specifically, the characteristic point selecting unit 130 may include an information storage unit 131, a function processing unit 133, and a point selecting unit 135 as illustrated in FIG. 2. As discussed above, the components illustrated in FIG. 2 correspond to a logical configuration.

The information storage unit 131 may store information about the charging and discharging profile of the cell group 50, identification information, specifications (spec.) information of the included cells 51, usage period, and usage history (S400).

The function processing unit 133 may perform function processing, etc. on the charging and discharging profile of the cell group 50 stored in the information storage unit 131 to generate a differential profile (S410).

For example, the function processing unit 133 may generate a differential profile representing a correspondence relationship between the capacity and the differential voltage of the cell group 50. As another example, the function processing unit 133 may also generate a differential profile representing a correspondence relationship between the voltage and the differential capacity of the cell group 50.

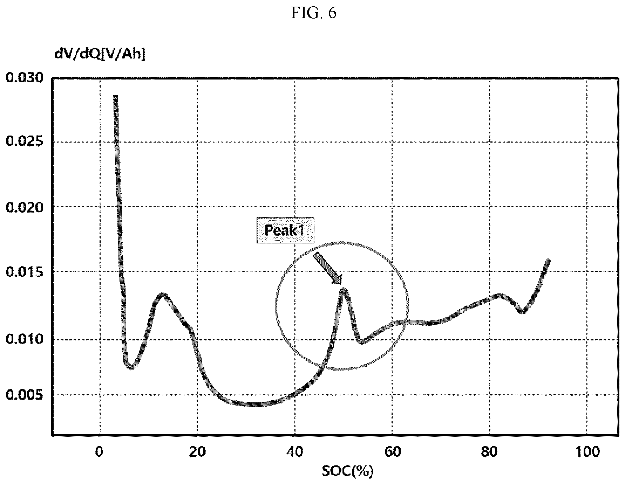

Here, the differential voltage is voltage differentiated with respect to the capacity, and may be expressed as "dV/dQ", and the unit may be [V/Ah]. If the charging and discharging profile that is the basis of the differential profile is a profile generated during the charging process, if the X-axis of the two-dimensional coordinate is set to SOC (or capacity) and the Y-axis is set to the differential voltage, the differential profile (differential voltage profile) may be expressed as a graph exemplified in FIG. 6.

Also, the differential capacity is capacity differentiated with respect to voltage, and may be expressed as "dQ/dV", and the unit may be [Ah/V]. It goes without saying that the differential profile (differential capacity profile) may be expressed as a two-dimensional graph by setting the X-axis of the two-dimensional coordinates to voltage and the Y-axis to differential capacity.

Hereinafter, as illustrated in FIG. 6, the differential profile is explained assuming that it is a differential voltage profile generated during the charging process of the cell group 50. However, by applying simple transformations such as symmetry movement and variable conversion, the technical idea of the present disclosure may be applied not only to cases where the differential profile is generated based on the charging and discharging profile generated during the discharging process, but also to cases where the differential profile (differential capacity profile) representing the correspondence relationship between the voltage and differential capacity of the cell group 50 is used.

When a differential profile is generated as described above, the point selecting unit 135 may select a peak of the differential profile as a characteristic point (S420).

As described above, the characteristic point is a point corresponding to the inflection point of the charging and discharging profile of the cell group 50. Specifically, the peak of the differential profile is a point where the sign of the slope changes in the differential profile, and is a point where the slope is 0. For example, the point corresponding to the maximum point of the differential profile is the peak of the differential profile. That is, since the characteristic point (inflection point) appears as a peak of a shape that is convex upward in the differential profile, the characteristic point may be selected more accurately and clearly by selecting a peak having the corresponding shape characteristic.

For example, when a differential profile representing a correspondence relationship between capacity and differential voltage is generated, the point selecting unit 135 may determine a capacity having a smallest corresponding differential voltage in the generated differential profile. In addition, the point selecting unit 135 may be configured to select a characteristic point among a plurality of peaks included in a capacity range greater than the determined capacity.

As another example, if a differential profile representing a correspondence relationship between voltage and differential capacity is generated, the point selecting unit 135 may determine a voltage having a largest corresponding differential capacity in the generated differential profile. In addition, the point selecting unit 135 may be configured to select a characteristic point among a plurality of peaks included in a voltage range greater than the determined voltage.

Hereinafter, with further reference to FIGS. 6 to 10, the specific technical contents of the present disclosure for selecting a characteristic point using a peak and diagnosing deterioration imbalance will be described.

FIG. 6 is a drawing illustrating a differential profile of a reference cell group. As defined above, the reference cell group refers to a cell group including cells in the BOL state, so the differential profile illustrated in FIG. 6 serves as a criterion for determining whether deterioration imbalance occurs.

As shown in FIG. 6, there may be multiple points that geometrically correspond to peaks in the differential profile of the reference cell group.

In the case of the cell 51 based on a secondary battery or the cell group 50 which is a collection of cells, since the intrinsic characteristic change of the negative electrode is concentrated in the middle region of the SOC, a peak (Peak1) corresponding to a maximum point may be included in the middle region of the SOC of the differential profile. For example, in the embodiment of FIG. 6, the peak (Peak1) may be included in a range of 40% to 70% of the SOC of the differential profile.

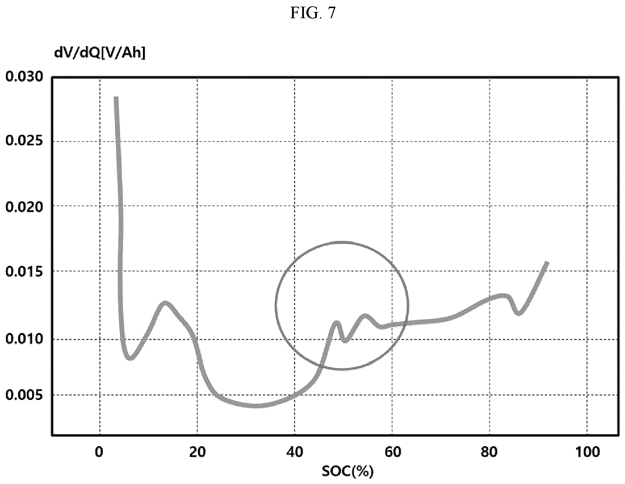

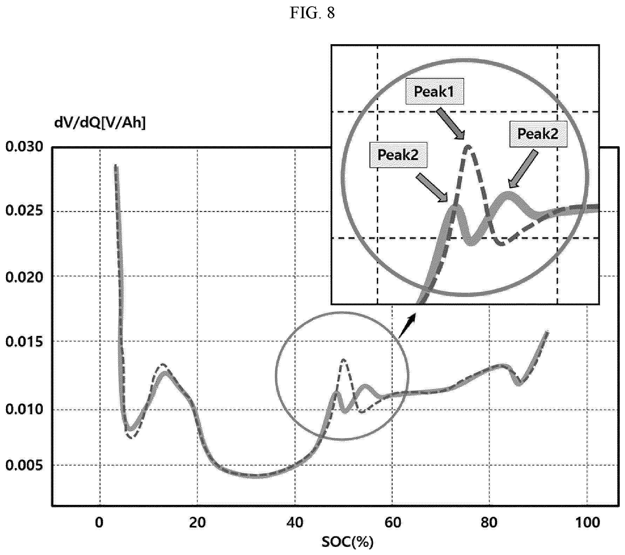

As confirmed in FIG. 6, in the case of the reference cell group, i.e., the cell group 50 in which deterioration imbalance does not occur, the characteristic point of the charging and discharging profile is single. In contrast, as confirmed in FIGS. 7 and 8, in the case of the deterioration imbalance cell group 50 in which the degree of deterioration of individual cells 51 is different from each other, a phenomenon of peak separation or differentiation (split) occurs, and thus multiple characteristic points (Peak2) may be detected.

For example, in the embodiment of FIG. 7, the point selecting unit 135 may determine the lowest differential voltage in the differential profile. For example, the differential voltage may be the lowest at about SOC 30%. The point selecting unit 135 may detect a characteristic point (Peak2) in a SOC section after the SOC corresponding to the lowest differential voltage. For example, the point selecting unit 135 may detect the characteristic point (Peak2) in a range of SOC 40% or more to SOC 70% or less.

In a case where a plurality of characteristic points are detected or selected in this way (S430, FIG. 4), the diagnosing unit 140 of the present disclosure may diagnose that a deterioration imbalance has occurred in the corresponding cell group 50 (S450).

In contrast, if a single characteristic point of the corresponding cell group 50 is detected, it may be considered that the degree of deterioration or aging of cells 51 belonging to the corresponding cell group 50 is at an equivalent level within the error range, and therefore the diagnosing unit 140 of the present disclosure may diagnose that no deterioration imbalance has occurred in the corresponding cell group 50 (S440). Of course, depending on the embodiment, even if a plurality of characteristic points are detected within a range that does not exceed the criterion error, it may be considered that a single characteristic point is detected.

Specifically, the change in the intrinsic characteristics of the negative electrode may be concentrated in the target SOC section included in a predetermined SOC range from the SOC corresponding to the lowest differential voltage in the differential profile. That is, if an imbalanced deterioration occurs in a plurality of cells 51, the states of the negative electrodes of the plurality of cells 51 may become different. Therefore, the diagnosing unit 140 may diagnose whether a deterioration imbalance occurs in the cell group 50 based on the information on the number of characteristic points in the target SOC section.

Since the cell 51 is likely to exhibit deteriorated driving performance and unusual behavior as it ages, it is desirable to configure the criterion error to be set variably, but to be set so that it becomes smaller as the usage period of the cell group 50 ages, that is, to be set so that the determination of deterioration imbalance becomes stricter.

When the diagnosis of the deterioration imbalance of the cell group 50 is made as described above, the diagnosing unit 140 may be configured to generate and output diagnostic data representing the same (S460).

The management control unit 150 may be configured to change the usage condition of the cell group 50 so that charging and discharging of the cell group 50 is restricted when a deterioration imbalance occurs in the cell group 50 based on the diagnostic data input from the diagnosing unit 140 (S470).

For example, the management control unit 150 may change the upper limit SOC and/or the lower limit SOC of the cell group 50 to prevent the deterioration of the cell group 50, where the deterioration imbalance has occurred, from becoming further unbalanced. Specifically, the management control unit 150 may decrease the upper limit SOC or increase the lower limit SOC. In addition, the management control unit 150 may decrease the upper limit SOC and increase the lower limit SOC.

According to an embodiment, it is preferable that the diagnosing unit 140 or the management control unit 150 of the present disclosure is configured to output information (identification information, deterioration severity information, etc.) about the cell group 50 in which deterioration imbalance has occurred to a user terminal or an info system of a vehicle.

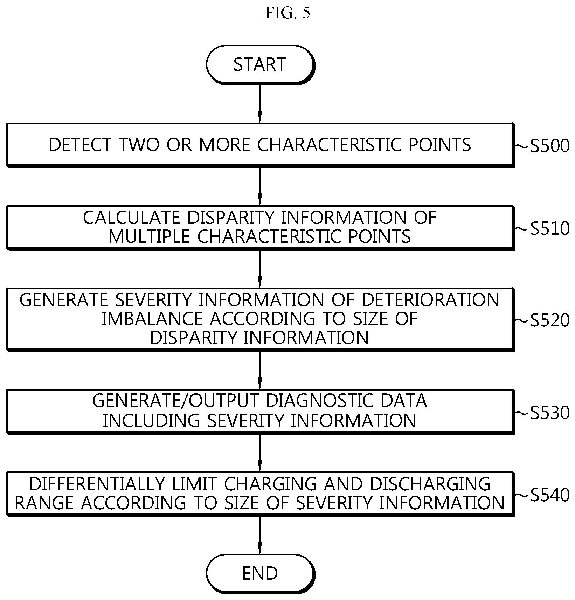

Below, the contents of other embodiments of the present disclosure will be described in detail with reference to FIG. 5, etc.

As described above, the characteristic information may include information on the number of characteristic points, but for implementation of a more preferred embodiment, the characteristic information may further include disparity information between the characteristic points when a plurality of characteristic points are detected (S500).

Specifically, the diagnosing unit 140 of the present disclosure may calculate disparity information of a plurality of characteristic points when data on a characteristic point is input from the characteristic point selecting unit 130 (S510). In addition, the diagnosing unit 140 may be configured to generate severity information that increases as the disparity information increases as information on the degree of deterioration imbalance (S520).

The disparity information may be generated by calculating the distance (D1, D2) between the plurality of characteristic points (based on SOC) or by statistically processing it (variance, weighted average, etc.).

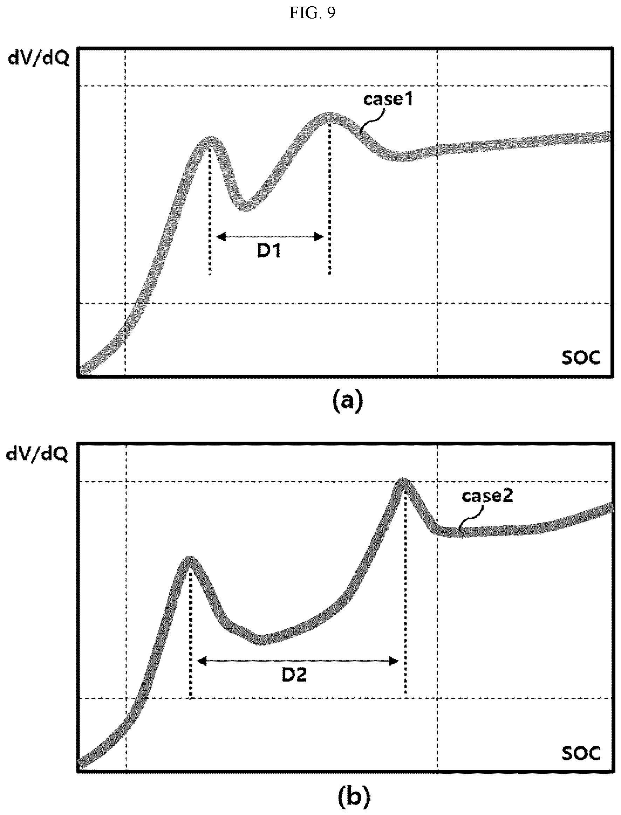

Based on the example of FIG. 9, in case 1, D1 ((a) of FIG. 9) becomes the criterion for disparity information, and in case 2, D2 ((b) of FIG. 9) becomes the criterion for disparity information. For reference, case 1 and case 2 represent the differential profiles of each of the deterioration imbalance cell groups 50 that have different deterioration characteristics.

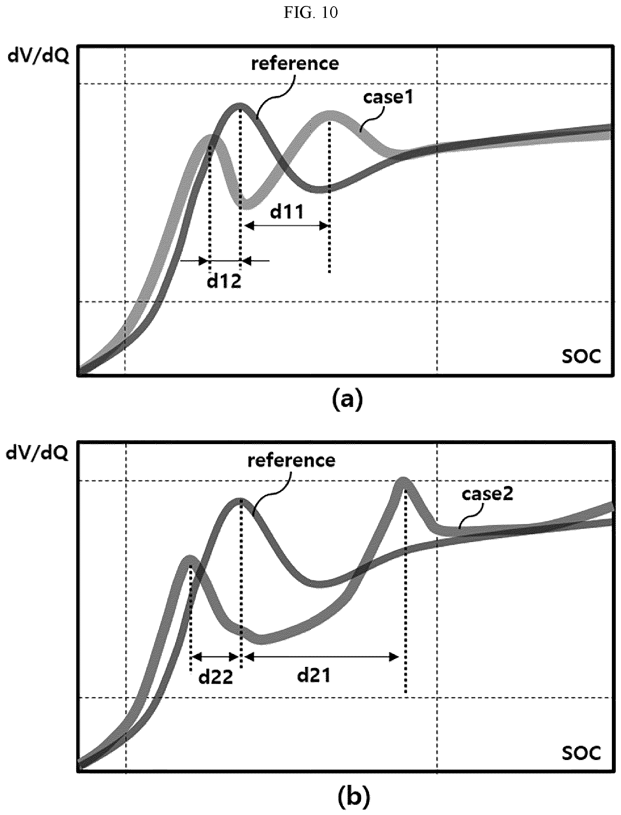

According to an embodiment, the disparity information may be generated using the distance between the characteristic point of the reference cell group and each characteristic point of the deterioration imbalance cell group 50 as illustrated in FIG. 10(a). In the case of FIG. 10(a), "d11 + d12" becomes the criterion for the disparity information, and in the case of FIG. 10(b), "d21 + d22" becomes the criterion for the disparity information.

The charging and discharging profile, the differential profile, the characteristic point information, etc. of the reference cell group may be stored and utilized in the criterion data storage unit 160, etc., which is communicatively connected to the diagnosing unit 140 of the present disclosure.

When the diagnosing unit 140 generates diagnostic data including the severity information and outputs it to the management control unit 150 (S530), the management control unit 150 controls charging and discharging of the corresponding cell group 50 to be limited depending on whether deterioration imbalance occurs.

In addition, the management control unit 150 may control the charging and discharging range of the cell group 50 to be differentially limited according to the size of the severity information, such as by making the charging and discharging range limitation relatively large for the cell group 50, if the cell group 50 has relatively large severity information (S540).

For example, in the embodiment of FIG. 10, since the severity information of case2 is greater than the severity information of case 1, the management control unit 150 may restrict the charging and discharging range of the cell group of case 2 more than the charging and discharging range of the cell group of case 1. For example, the management control unit 150 may decrease the upper limit SOC of the cell group of case 1 by 10% and increase the lower limit SOC by 10%. In addition, the management control unit 150 may decrease the upper limit SOC of the cell group of case 2 by 15% and increase the lower limit SOC by 15%.

That is, the battery management apparatus 100 may accurately quantify the occurrence of deterioration imbalance in each of the plurality of cell groups 50 constituting the target battery 10, as well as diagnose the degree of deterioration imbalance, and thus may more precisely implement the replacement period for a specific cell group 50, setting of usage restriction ranges, and charging and discharging control.

Meanwhile, the battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS.

In addition, the battery management apparatus 100 according to the present disclosure may be provided in a battery pack. That is, the battery pack according to the present disclosure may include the above-described battery management apparatus 100 and at least one cell group 50.

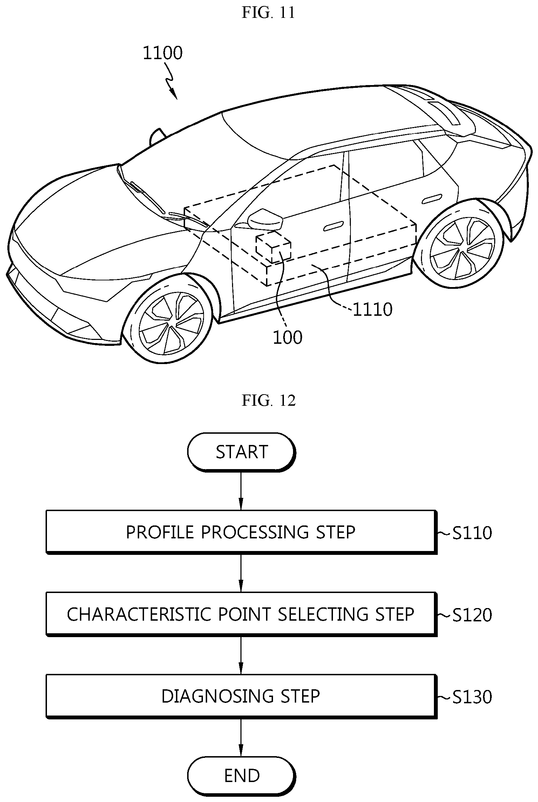

FIG. 11 is a diagram schematically showing a vehicle 1100 according to another embodiment of the present disclosure.

Referring to FIG. 11, the battery pack 1110 according to an embodiment of the present disclosure may be included in a vehicle 1100 such as an electric vehicle (EV) or a hybrid vehicle (HV). Additionally, the battery pack 1110 may drive the vehicle 1100 by supplying power to the motor through an inverter provided in the vehicle 1100. Here, the battery pack 1110 may include the battery management apparatus 100. In this case, the battery management apparatus 100 may be an on-board diagnostic device included in the vehicle 1100.

FIG. 12 is a diagram schematically showing a battery management method according to still another embodiment of the present disclosure.

Referring to FIG. 12, the battery management method may include a profile processing step (S110), a characteristic point selecting step (S120), and a diagnosing step (S130).

Preferably, each step of the battery management method may be performed by the battery management apparatus 100. Hereinafter, contents overlapping with the previously described contents will be omitted or briefly described.

The profile processing step (S110) is a step of obtaining a charging and discharging profile of a cell group in which a plurality of cells are electrically connected, and may be performed by the profile processing unit 120.

The characteristic point selecting step (S120) is a step of selecting a characteristic point corresponding to an inflection point in the charging and discharging profile, and may be performed by the characteristic point selecting unit 130.

For example, the characteristic point selecting unit 130 may specify an inflection point in the charging and discharging profile and select a characteristic point corresponding to the specified inflection point. As another example, the characteristic point selecting unit 130 may specify a peak in a differential profile and select a characteristic point corresponding to the specified peak.

Preferably, the characteristic point selecting unit 130 may select a characteristic point in a SOC middle region (e.g., a SOC 40% to 70% region) among the entire SOC range of the cell group 50.

The diagnosing step (S130) is a step of diagnosing a deterioration imbalance of the cell group using characteristic information of the characteristic point, and may be performed by the diagnosing unit 140.

For example, the diagnosing unit 140 may diagnose that deterioration imbalance does not occur in the cell group 50 if the number of characteristic points is single. As another example, the diagnosing unit 140 may diagnose that deterioration imbalance occurs in the cell group 50 if the number of characteristic points is multiple.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### [Explanation of reference signs]

10: target battery
50: cell group
51: cell
100: battery management apparatus
110: measuring unit
120: profile processing unit
130: characteristic point selecting unit
131: information storage unit
133: function processing unit
135: point selecting unit
140: diagnosing unit
150: management control unit
160: criterion data storage unit
1100: vehicle
1110: battery pack

## Claims

1. A battery management apparatus, comprising:
a profile processing unit configured to obtain a charging and discharging profile of a cell group in which a plurality of cells are electrically connected;
a characteristic point selecting unit configured to select a characteristic point corresponding to an inflection point in the charging and discharging profile; and
a diagnosing unit configured to diagnose a deterioration imbalance of the cell group using characteristic information including information on the number of characteristic points.

2. The battery management apparatus according to claim 1,
wherein the diagnosing unit is configured to diagnose that the deterioration imbalance does not occur in the cell group if the number of characteristic points is single, and
wherein the diagnosing unit is configured to diagnose that the deterioration imbalance occurs in the cell group if the number of characteristic points is multiple.

3. The battery management apparatus according to claim 1,
wherein the charging and discharging profile is a profile that represents a correspondence relationship between voltage and capacity of the cell group,
wherein the characteristic point selecting unit includes:
a function processing unit configured to generate a differential profile, which is a profile representing a correspondence relationship between the capacity and a differential voltage of the cell group or a correspondence relationship between the voltage and a differential capacity of the cell group, based on the charging and discharging profile; and
a point selecting unit configured to select the characteristic point in the differential profile.

4. The battery management apparatus according to claim 3,
wherein when the differential profile representing the correspondence relationship between the capacity and the differential voltage is generated, the point selecting unit is configured to determine a capacity having a smallest corresponding differential voltage in the generated differential profile and select the characteristic point among a plurality of peaks included in a capacity range greater than the determined capacity.

5. The battery management apparatus according to claim 3,
wherein when the differential profile representing the correspondence relationship between the voltage and the differential capacity is generated, the point selecting unit is configured to determine a voltage having a largest corresponding differential capacity in the generated differential profile and select the characteristic point among a plurality of peaks included in a voltage range greater than the determined voltage.

6. The battery management apparatus according to claims 4 or 5,
wherein the point selecting unit is configured to select a peak, in which a SOC of the cell group is located in a range of 40% or more and 70% or less, among the peaks as the characteristic point.

7. The battery management apparatus according to claim 1, further comprising:
a management control unit configured to change a usage condition of the cell group so that charging and discharging of the cell group is limited, when the deterioration imbalance is diagnosed to occur in the cell group.

8. The battery management apparatus according to claim 1,
wherein when the characteristic point is multiple, the characteristic information further includes disparity information between the characteristic points, and
wherein the diagnosing unit is configured to generate diagnostic data including severity information that increases as the disparity information increases as information on the degree of the deterioration imbalance.

9. The battery management apparatus according to claim 8, further comprising:
a management control unit configured to change a usage condition of the cell group so that a charging and discharging range of the cell group is differentially limited according to a size of the disparity information, when the deterioration imbalance is diagnosed to occur in the cell group.

10. A battery pack, comprising the battery management apparatus according to any one of claims 1 to 9.

11. A vehicle, comprising the battery management apparatus according to any one of claims 1 to 9.

12. A battery management method, comprising:
a profile processing step of obtaining a charging and discharging profile of a cell group in which a plurality of cells are electrically connected;
a characteristic point selecting step of selecting a characteristic point corresponding to an inflection point in the charging and discharging profile; and
a diagnosing step of diagnosing a deterioration imbalance of the cell group using characteristic information of the characteristic point.
